# EUROPÄISCHE PATENTANMELDUNG

(11) **EP 0 863 225 A1**
(43) Veröffentlichungstag der Anmeldung: **09.09.1998**
(21) Anmeldenummer: 98104007.4
(22) Anmeldetag: 06.03.1998
(51) Int. Cl.: C23C 14/26

(54) **Einspannsystem zur Positionierung und Kontaktierung von Verdampfern in Metallisierungsanlagen**

(30) Priorität: 06.03.1997 DE 19709218
(71) Anmelder: Elektroschmelzwerk Kempten GmbH, 81737 München (DE)
(72) Erfinder: Lerf, Siegfried, 87477 Sulzberg (DE)
(74) Vertreter: Potten, Holger

(57) **Zusammenfassung**

Die Erfindung betrifft einen Spannkopf (1, 2) zum Befestigen von Verdampfern (5) in Metallisierungsanlagen, dadurch gekennzeichnet, daß der Spannkopf (1 bzw.2) aus mindestens einem Oberteil (3) und mindestens einem Unterteil (4) besteht, welche den Verdampfer in der gewünschten Position fixieren.

## Beschreibung

Die Erfindung betrifft ein Einspannsystem zur Positionierung und Kontaktierung von Verdampfern in Metallisierungsanlagen.

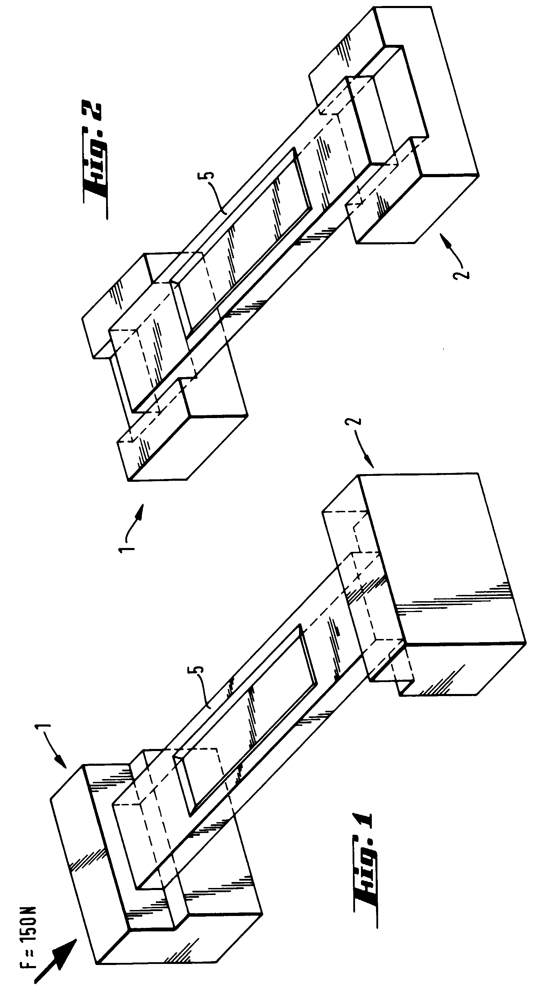

Bisher werden Verdampfer in Metallisierungsanlagen stirnseitig (Fig.1) oder seitlich (Fig.2) fixiert.

Bei stirnseitiger Einspannung wird die Lagefixierung des Verdampfers 5 durch eine axial federnd gelagerte bewegliche Stromzuführung 1, 2 realisiert, die gleichzeitig zur Kompensation der thermischen Dehnung während der Aufheizung bzw. während des Betriebs des Verdampfers dient. Die Verdampfer werden mit einer definierten axialen Anpreßkraft gegen die stirnseiteigen Kontaktflächen gepreßt. Planparallele Verdampferstirnseiten und planparallele Kontaktflächen der Einspannung sind dabei Voraussetzung für eine homogene Stromdichteverteilung. Die vollflächige Kontaktierung des Verdampfers muß beim Einbau durch den Operator visuell kontrolliert werden, da dies nicht durch konstruktive Maßnahmen sichergestellt ist.

Bei Dreieckverdampfern ergibt sich geometriebedingt das Problem einer evtl. unerwünschten Kippung des Verdampfers um dessen Längsachse. Gelegentlich wird daher die Unterkante des Verdampfers angefast und so eine definierte Auflage ermöglicht.

Bei stirnseitiger Einspannung wird zur besseren Kontaktierung und zum Ausgleich von Oberflächenrauhigkeiten i.d.R. eine Graphitfolie zwischen Verdampfer und Einspannung eingelegt.

Die seitliche Einspannung von Rechteckverdampfern 5 basiert auf einer formschlüssigen Klemmung des Verdampfers, wobei die Klemmung an den Verdampferenden in zwei stromführenden Aufnahmen (1 und 2 in Fig. 2) erfolgt. Der Stromfluß erfolgt über die Seitenflächen und die Unterseite 6 des Verdampfers 5. Bei der seitlichen Einspannung wird zur besseren Kontaktierung und zum Ausgleich von Oberflächenrauhigkeiten i.d.R. ebenfalls eine Graphitfolie zwischen Verdampfer 5 und Einspannung 1, 2 eingelegt. Zur Erleichterung des Einbaus und zur Vermeidung einer Beschädigung des Verdampfers und der Grafitfolie sind die Kanten auf der Unterseite 6 abgerundet. Der Verdampfer ist axial in der Einspannung nicht fixiert, so daß eine thermische Dehnung in axialer Richtung durch eine Verschiebung des Verdampfers ausgeglichen wird und keine Biegebeanspruchung auftritt. Bei der seitlichen Einspannung der Verdampfer liegt keine definierte Kontaktierung zwischen Verdampfer und Stromzuführung vor, d.h. die Verdampfer werden nicht mit einer definierten Kraft gegen die Stromzuführung gepreßt.

Bisher ist die seitliche Einspannung nur für Rechteckverdampfer möglich. Für Dreieckverdampfer existiert dagegen keine technische Lösung.

Gegenstand der Erfindung ist ein Spannkopf zum Befestigen von Verdampfern in Metallisierungsanlagen, dadurch gekennzeichnet, daß der Spannkopf (1 bzw.2 in Fig. 3a) aus mindestens einem Oberteil (3 in Fig. 3a) und mindestens einem Unterteil (4 in Fig. 3a) besteht, welche den Verdampfer 5 in der gewünschten Position fixieren.

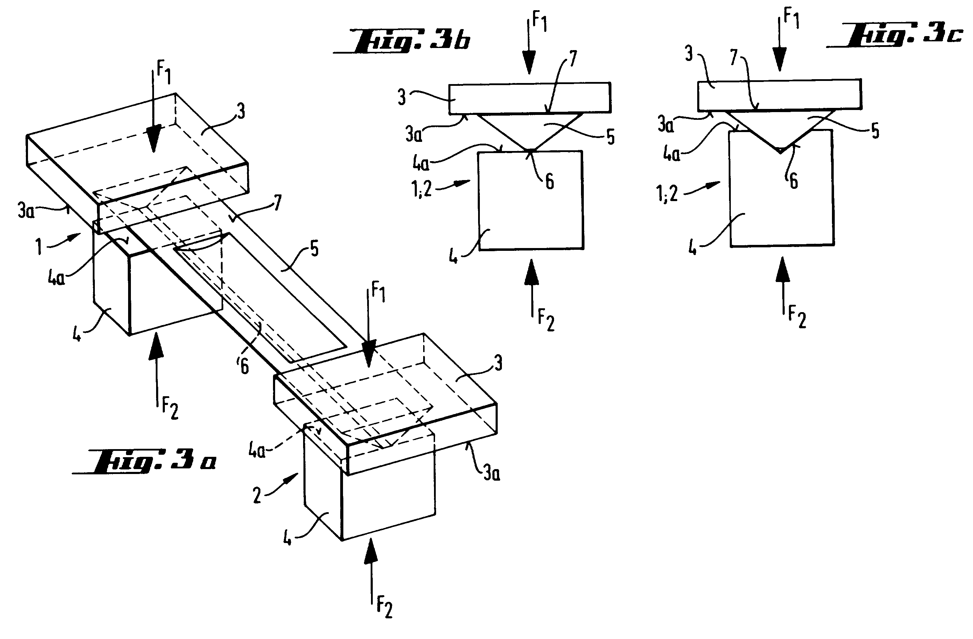

Die Fläche des Spannkopfes 1, 2 die mit der Unterseite 6 des Verdampfers 5 in Berührung kommt, kann entweder eine ebene Oberfläche 4a aufweisen (Fig. 3b) oder an die Kontur des Verdampfers derart angepaßt werden, daß eine formschlüssige Aufnahme des Verdampfers vorliegt (Fig. 3c).

Der Verdampfer 5 kann sich axial im Spannkopf 1, 2 verschieben, wodurch die thermische Dehnung des Verdampfers ermöglicht wird.

Im erfindungsgemäßen Einspannsystem liegt der Verdampfer 5 mit seiner Oberfläche 7 von der die Verdampfung erfolgt, vorzugsweise an einem Teil der Unterseite 3a des Spannkopfoberteils 3 an und wird mit einer vorzugsweise definierten Kraft gegen diese Unterseite gedrückt. Die dazu benötigte Kraft kann entweder auf das Oberteil 3 (F₁) oder auf das Unterteil 4 (F₂) wirken.

Die Kraft kann dabei beispielsweise mechanisch vorzugsweise über eine einstellbare Feder- oder Exzenterspannung aufgebracht werden.

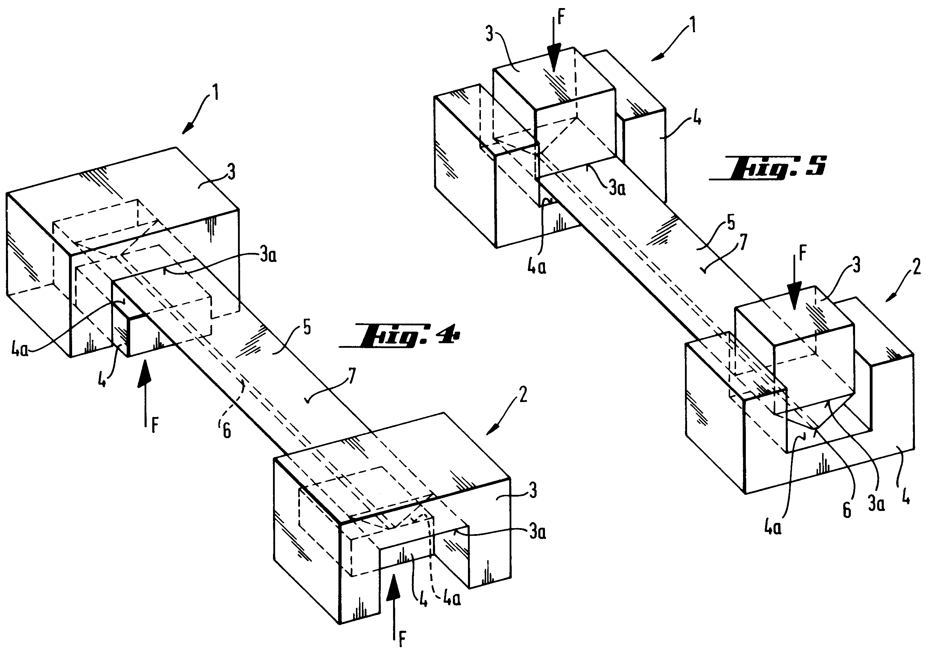

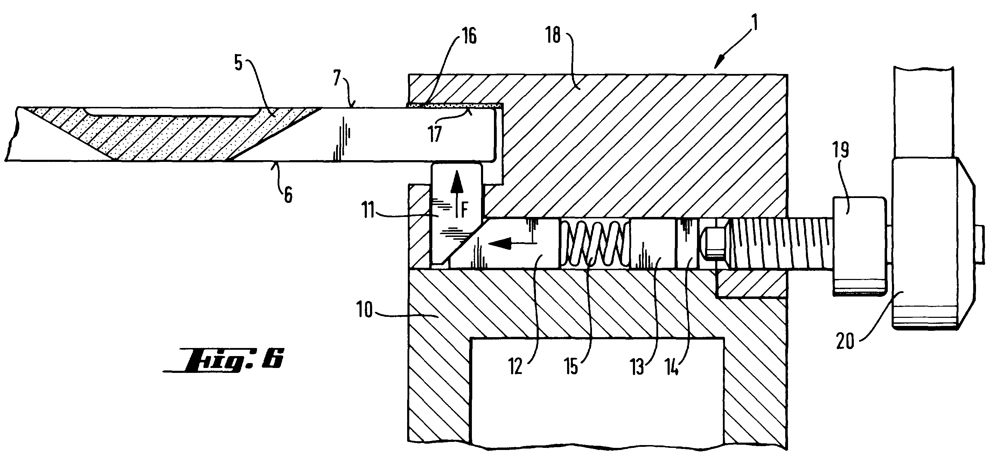

Beispielhaft zeigen Fig. 4 und Fig. 5 schematisch je eine Ausführung für Kraftaufbringung auf das Spannkopfunter- bzw. -oberteil.

In den erfindungsgemäßen Spannkopf kann falls notwendig ein Kühlsystem integriert sein.

Vorzugsweise ist der erfindungsgemäße Spannkopf aus einem gut elektrisch- und wärmeleitenden Material, vorzugsweise aus Kupfer hergestellt.

Zwischen dem stromführenden Teil des Spannkopfes und dem Verdampfer kann zur besseren Kontaktierung eine Graphitfolie gelegt werden. Der nicht stromführende Teil des Spannkopfes kann elektrisch gegen den Verdampfer isoliert werden. Dies kann beispielsweise durch eine BN-Zwischenschicht geschehen. Diese BN-Zwischenschicht kann als Suspension oder in Form eines Plättchens aufgebracht werden.

Die Erfindung betrifft ferner ein Einspannsystem für Verdampfer in Metallisierungsanlagen bei dem der Verdampfer zwischen zwei Halterungen aus elektrisch leitendem Material befestigt ist, dadurch gekennzeichnet, daß als Halterung jeweils ein erfindungsgemäßer Spannkopf vorhanden ist, der form- und/oder kraftschlüssig an der Stromzuführung der Metallisierungsanlage befestigt ist.
Das erfindungsgemäße Einspannsystem bietet gegenüber dem Stand der Technik folgende Vorteile:

Es ermöglicht die Kraft- und ggf. formschlüssige Einspannung von Verdampfern mit sehr guter Reproduzierbarkeit der Einspannverhältnisse.

Es ermöglicht die Einspannung von Verdampfern beliebigen Querschnittes. So ist beispielsweise der Einsatz von Verdampfern mit Rechteck-, Dreieck-, Trapezquerschnitt möglich.

Es erleichtert die Vermeidung von Bedienerfehlern beim Einbau/Wechseln von Verdampfern.

Fig. 6 zeigt schematisch eine bevorzugte Ausführungsform eines erfindungsgemäßen Einspannkopfes. Auf der wassergekühlten Stromzuführung 10 der Metallisierungsanlage ist mittels Schraubenverbindung der erfindungsgemäße Einspannkopf 1 befestigt. Der Verdampfer 5 wird mittels vier Druckadaptern 11, 12, 13, 14, die über eine Druckfeder 15 miteinender kraftschlüssig verbunden sind, gegen die mit einer Graphitfolie 16 belegte Unterseite 17 des Einspannoberteils 18 gepresst. Der Druck, mit dem der Verdampfer an die Unterseite des Einspannoberteils gepreßt wird, läßt sich durch Druckschraube 19 mittels eines Drehmomentschraubers 20 definiert und sehr exakt einstellen.

Die Druckadapter bestehen vorzugweise aus BN. Die Erfindung betrifft daher ebenfalls Druckadapter zur Fixierung von Verdampfern in Metallisierungsanlagen, die dadurch gekennzeichnet sind, daß sie aus BN bestehen.

Neben den bereits genannten generellen Vorteilen des erfindungsgemäßen Einspannkopfes hat die besonders bevorzugte Ausführungsform noch die folgenden Vorteile gegenüber den bekannten Systemen:
- Keine seitlichen Scherkräfte durch Achsenversatz.
- Spannmimik liegt direkt auf der wassergekühlten Stromzuführung
- Spannmimik ist geschützt gegen Verschmutzung
- Keine Zerstörung der Spannmimik durch Stromfluß
- Kein Abscheren der Grafitfolie

## Patentansprüche

1. Spannkopf zum Befestigen von Verdampfern in Metallisierungsanlagen, dadurch gekennzeichnet, daß der Spannkopf (1 bzw. 2 in Fig. 3a) aus mindestens einem Oberteil (3) und mindestens einem Unterteil (4) besteht, welche den Verdampfer (5) in der gewünschten Position fixieren.

2. Spannkopf gemäß Anspruch 1, dadurch gekennzeichnet, daß der Verdampfer (5) mit seiner Oberfläche (7), von der die Verdampfung erfolgt, an einem Teil der Unterseite (3a) des Spannkopfoberteils (3) anliegt und mit einer definierten Kraft gegen diese Unterseite (3a) gedrückt wird.

3. Spannkopf gemäß Anspruch 2, dadurch gekennzeichnet, daß die Kraft (F₁), mit der die Verdampferoberfläche (7) gegen die Unterseite (3a) des Spannkopfoberteils (3) gedrückt wird, auf das Spannkopfoberteil (3) wirkt.

4. Spannkopf gemäß Anspruch 2, dadurch gekennzeichnet, daß die Kraft (F₂), mit der die Verdampferoberfläche (7) gegen die Unterseite (3a) des Spannkopfoberteils (3) gedrückt wird, auf das Spannkopfunterteil (4) wirkt.

5. Spannkopf gemäß einem oder mehreren der Ansprüche 1 bis 4, dadurch gekennzeichnet, daß ein Kühlsystem integriert ist.

6. Einspannsystem für Verdampfer in Metallisierungsanlagen bei dem der Verdampfer (5) zwischen zwei Halterungen aus elektrisch leitendem Material befestigt ist, dadurch gekennzeichnet, daß als Halterung jeweils ein Spannkopf (1, 2) gemäß einem der Ansprüche 1 bis 5 vorhanden ist, der form- und/oder kraftschlüssig an der Stromzuführung der Metallisierungsanlage befestigt ist.

7. Druckadapter zur Fixierung von Verdampfern in Metallisierungsanlagen, dadurch gekennzeichnet, daß sie aus BN bestehen.
